# FASCICULE DE BREVET EUROPEEN

(11) **EP 1 022 846 B1**
(45) Date de publication et mention de la délivrance du brevet: **13.08.2003**
(21) Numéro de dépôt: 00400136.8
(22) Date de dépôt: 19.01.2000
(51) Int. Cl.: H03B 5/02, H03L 7/099

(54) **Circuit d'oscillation avec dynamique étendue**
Schwingschaltung mit breitem Dynamikbereich
Oscillation circuit with wide dynamic range

(30) Priorité: 20.01.1999 FR 9900740
(43) Date de publication de la demande: 26.07.2000
(73) Titulaire: SAGEM S.A., 75015 Paris (FR)
(72) Inventeur: Romao, M. Fernando, 78360 Montesson (FR)
(74) Mandataire: Schmit, Christian Norbert Marie

(56) Documents cités:
- EP-A- 0 599 505
- EP-A- 0 755 112
- US-A- 4 713 631
- PATENT ABSTRACTS OF JAPAN vol. 010, no. 186 (E-416), 28 juin 1986 (1986-06-28) & JP 61 032603 A (FUJITSU LTD), 15 février 1986 (1986-02-15)

## Description

La présente invention a pour objet un circuit d'oscillation, comportant un oscillateur commandé par une tension électrique, avec une dynamique étendue. Elle est principalement utilisable dans les domaines de l'électronique où on doit produire des signaux sinusoïdaux. Ceci est notamment le cas dans la téléphonie mobile où, par exemple, un signal reçu par une antenne d'un téléphone mobile est mélangé avec des signaux sinusoïdaux produits par le téléphone mobile. On obtient ainsi des signaux dont une valeur de fréquence est par exemple plus basse qu'une valeur de fréquence du signal reçu. Des circuits d'oscillation permettent de produire ces signaux sinusoïdaux. Le but de l'invention est de réaliser un circuit d'oscillation dont une sensibilité au bruit est diminuée et dont une pureté spectrale augmentée.

Les circuits d'oscillation fabriqués actuellement comportent un oscillateur commandé par une tension électrique. Cet oscillateur commandé par une tension électrique produit en sortie un signal sinusoïdal à une valeur de fréquence demandée. Dans la plupart des cas, ce circuit d'oscillation comporte en outre un circuit comparateur de phase à deux entrées et une sortie. Sur une première entrée de ce comparateur de phase est appliqué un signal sinusoïdal de consigne à une valeur de fréquence en général fixe. Sur la deuxième entrée est appliqué, notamment par l'intermédiaire d'un circuit diviseur de fréquence par N, le signal sinusoïdal de sortie de l'oscillateur. La sortie de ce comparateur de phase est filtrée par un filtre passe-bas de boucle dont une sortie est reliée à une entrée de commande de l'oscillateur. Cette structure permet d'asservir une valeur de fréquence à une valeur de consigne.

Ce signal en sortie du filtre passe-bas de boucle est un signal dont une valeur de tension varie dans un intervalle, par exemple entre 0,5 et 2,5 volts. L'oscillateur comporte en outre une diode varicap à capacité variable. Ainsi, cette tension de réglage est appliquée, ou au moins partie, aux bornes de la diode varicap. Une polarisation de cette diode varicap par la tension de réglage est telle que la diode varicap se retrouve polarisée en inverse. Une diode varicap polarisée en inverse est équivalente à un condensateur entre son anode et sa cathode et dont une valeur de capacité est variable. Une valeur de capacité de cette diode varicap dépend de la valeur de la tension de réglage appliquée à ses bornes.

Une variation linéaire de la tension de réglage aux bornes de la diode varicap produit une variation suivant une loi hyperbolique de la valeur de la capacité disponible aux bornes de la diode varicap. Ainsi, il apparaît avec ce type de loi qu'une sensibilité d'un tel composant est très variable selon une valeur de tension électrique à partir de laquelle l'oscillateur est commandé. La sensibilité correspond à une variation de tension qu'il faut produire pour avoir une variation déterminée d'une valeur de capacité. En générale, plus la valeur de tension à partir de laquelle l'oscillateur est commandé diminue et plus la sensibilité augmente et ce de manière exponentielle.

Comme la tension de réglage varie dans un intervalle fixé, alors la valeur de la capacité du condensateur varie, elle aussi, dans un intervalle fixé, à priori connu. Dans la plupart des cas, l'oscillateur comporte un filtre résonant à une fréquence de résonance. Un des éléments du filtre résonant est la diode varicap. Ainsi, une valeur de la fréquence de résonance dépend d'une valeur de capacité du condensateur équivalent aux bornes de la diode varicap. Une conséquence immédiate de ceci est que la valeur de la fréquence de résonance du filtre résonant est variable en fonction de la tension de réglage. Ainsi, une valeur de fréquence du signal en sortie de l'oscillateur varie dans un intervalle fixé, représentant une dynamique de l'oscillateur. Cette dynamique dépend donc de l'intervalle dans lequel une valeur de la tension de réglage peut varier. De plus, en fonction de la valeur de la tension de réglage, la sensibilité de la diode varicap et par conséquent de l'oscillateur peut être plus ou moins grande.

Actuellement, lorsqu'on veut obtenir une dynamique plus grande, une solution consiste à augmenter l'intervalle dans lequel la valeur de la tension de réglage varie. Pour augmenter cet intervalle, on augmente dans un premier temps une valeur de la tension d'alimentation du comparateur de phase.

Cette solution connue présente des problèmes car elle induit une diminution d'un rapport signal sur bruit du circuit oscillateur. En effet, le comparateur de phase utilisé comporte un dispositif de pompes à charge alimenté par une source de potentiel d'alimentation bruyante. Ce dispositif de pompe à charge est un dispositif comportant des sources de courant. Une source de courant est généralement réalisée à partir de transistors notamment bipolaires. Ces transistors doivent être polarisés par un courant de polarisation. Or, dans cette solution connue on augmente la valeur de la tension d'alimentation pour augmenter la dynamique en sortie de l'oscillateur ce qui revient à augmenter une valeur d'un courant de polarisation. En pratique, pour augmenter une valeur du courant de polarisation on réalise une commutation entre une première source de potentiel d'alimentation du comparateur de phase, par exemple de 3V, et une deuxième source de potentiel d'alimentation de valeur plus élevée, par exemple de 4,5 V.

Cette deuxième source de potentiel est obtenue à partir de la première source de potentiel notamment par un dispositif survolteur. Un tel survolteur produit du bruit malgré des dispositifs de filtrage présents en sortie. Ce bruit se propage par l'intermédiaire du courant de polarisation dans le comparateur de phase et se superpose au signal de réglage, créant ainsi des discontinuités sur ce dernier.

Ces problèmes se traduisent en sortie par une dégradation de la pureté spectrale du signal ainsi produit. En théorie, un oscillateur parfait produit un signal comportant une composante fréquentielle unique à la fréquence considérée. Dans la réalité, on n'a pas une composante fréquentielle unique mais un ensemble de composantes fréquentielles formant une bande de fréquences. Il faut réduire le plus possible cette bande pour se rapprocher de la théorie et obtenir ainsi une composante fréquentielle unique. Le filtre de boucle a notamment en charge d'éliminer ces discontinuités.

Le circuit d'oscillation ainsi constitué par le comparateur de phase le filtre de boucle et l'oscillateur constituent un dispositif d'asservissement en phase, appelé PLL pour Phase Locked Loop, soit boucle à verrouillage de phase en français. Une telle boucle est caractérisée notamment par une rapidité de réponse à un saut de fréquence. Cette rapidité est d'autant plus grande que la bande passante du filtre de boucle est grande. Cependant une élimination des discontinuités sur le signal de réglage est d'autant meilleure que la bande passante du filtre de boucle est faible. Les besoins sont donc antagonistes.

Lorsque ce circuit d'oscillation est utilisé dans la téléphonie mobile, notamment celle définie par la norme GSM, la rapidité doit être inférieure à la durée d'une fenêtre temporelle et demie, émise ou reçue, c'est-à-dire de l'ordre de 0,85 milliseconde. En effet, à chaque nouvelle trame on change de valeur de fréquence. Ainsi le filtre de boucle est défini principalement en fonction des caractéristiques de fonctionnement souhaitées pour le dispositif d'asservissement. Avec ces caractéristiques de fonctionnement souhaitées pour le dispositif d'asservissement, on ignore que le dispositif d'alimentation est générateur de bruit. Ainsi, le filtre de boucle est un filtre passe-bas, de bande passante de l'ordre de 200 KHz. De plus, ce filtre de boucle est un filtre du premier ordre c'est-à-dire que l'atténuation en dehors de la bande passante est de six décibels par octave. Ainsi un bruit présent en entrée du filtre passe-bas n'est pas complètement éliminé en sortie de ce filtre passe-bas. Il est donc appliqué à l'oscillateur, produisant ainsi du bruit en sortie de cet oscillateur. Ce bruit a pour conséquence notamment un élargissement, dans le domaine spectral, de la bande de fréquences associée à une représentation spectrale du signal en sortie de l'oscillateur.

En outre, quand on augmente une valeur de l'intensité des sources de courant du comparateur de phase, on augmente une consommation du circuit d'oscillation. Une augmentation de la consommation du courant induit immédiatement une diminution de la durée d'autonomie d'une batterie, par exemple, d'un téléphone mobile. Une valeur généralement observée de la consommation de courant d'une pompe à charge est de l'ordre de trois milliampères.

Une autre solution à ce problème a été proposée. Il s'agit de l'utilisation de circuits d'oscillation décalables en fréquence. Dans cette solution le comparateur de phase est alimenté seulement par la première source de potentiel. Ainsi la tension de réglage à l'entrée de l'oscillateur reste constante et est incluse dans l'intervalle compris entre 0,5 volt et 2,5 volts. Dans cette solution, on rajoute en série avec la diode varicap une deuxième diode varicap sur laquelle on applique à la demande une valeur de potentiel parmi deux. Dans ce cas, cette deuxième diode varicap possède deux valeurs de capacité possibles qui se retrouvent en série avec la diode varicap sur laquelle est appliquée la tension de réglage. On obtient bien ainsi par commutation une augmentation de la dynamique disponible en sortie de l'oscillateur.

Cette solution n'est pas encore optimale. En effet, la deuxième diode varicap est toujours soumise à des bruits car elle est reliée, à des résistances près, à l'alimentation. Cette alimentation est bruyante. La deuxième diode varicap est donc soumise au bruit issu notamment de l'alimentation. De plus, un dispositif mis en place pour obtenir deux niveaux de potentiel applicables sur la deuxième diode varicap consomme lui aussi du courant.

Une solution comparable utilisant seulement une diode varicap est révélee dans le document US 4 713 631.

L'invention se propose de remédier à ces problèmes en réalisant l'augmentation de la dynamique en sortie de l'oscillateur tout en réduisant le bruit en sortie de l'oscillateur. Pour cela, on réalise une commutation d'alimentation directement sur une entrée d'alimentation de l'oscillateur. De plus cette entrée d'alimentation est équivalente à une impédance de forte valeur. C'est-à-dire que les potentiels appliqués en entrée n'induisent pas de valeurs de courant supérieures à une valeur de l'ordre de 100 µA. En conséquence de quoi une charge, par exemple un filtre passe bas, appliquée à cette entrée ne perturbe pas les réglages de l'oscillateur. Ainsi, un filtre passe-bas de valeur de fréquence de coupure de l'ordre de la dizaine de Hertz ou moins est facilement réalisable. Ce filtre passe-bas a pour fonction principale de filtrer des signaux issus des sources de potentiel.

En outre, une consommation en courant de la deuxième alimentation est considérablement réduite par rapport à la première méthode. En effet on passe d'une valeur de consommation de l'ordre de trois milliampères à une valeur de consommation de l'ordre de cent microampères. On augmente ainsi une durée d'autonomie de la batterie du téléphone mobile tout en réduisant une complexité de réalisation d'un tel circuit d'oscillation.

La présente invention concerne donc un circuit d'oscillation comportant un oscillateur commandé par une tension électrique sur une première entrée, et un dispositif de commande relié à cette entrée, le dispositif de commande étant alimenté par une première source de potentiel, et produisant un signal de réglage, caractérisé en ce que cet oscillateur comporte une deuxième entrée reliée à un dispositif de commutation d'alimentation entre cette première source de potentiel et une deuxième source de potentiel.

L'invention sera mieux comprise à la lecture de la description qui suit et à l'examen des figures qui l'accompagnent. Celles-ci ne sont présentées qu'à titre indicatif et nullement limitatif de l'invention. Les figures montrent :
- Figure 1 : un premier circuit d'oscillation selon l'état de la technique dans lequel le comparateur de phase comporte un dispositif de commutation d'alimentation ;
- Figure 2 : un deuxième circuit d'oscillation selon l'état de la technique proposé comme solution aux problèmes posés par le premier circuit d'oscillation ;
- Figure 3 : un circuit d'oscillation selon l'invention.

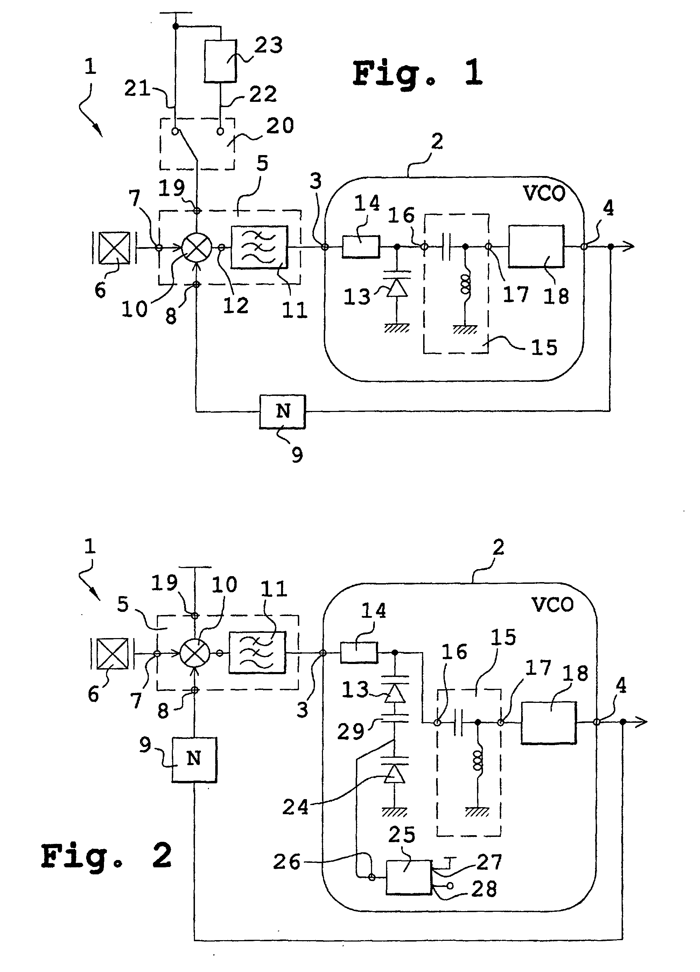

La figure 1 montre un circuit d'oscillation 1 selon l'état de la technique. Ce circuit d'oscillation 1 comporte un oscillateur 2 commandé par une tension couramment abrégé en VCO pour Voltage Controlled Oscillator ou OCT pour Oscillateur Contrôlé par une Tension en français. Cet oscillateur 2 commandé par une tension comporte une entrée 3 et une sortie 4. Cet oscillateur 2 commandé par une tension a en charge de fournir, par la sortie 4, un signal dont une valeur de fréquence est comprise dans un intervalle délimité par une valeur de fréquence haute et une valeur de fréquence basse. Pour parler de cet intervalle fréquentiel on utilise le terme de dynamique. Pour produire ce signal de sortie en sortie 4 de l'oscillateur 2 on applique par l'entrée 3 un signal de réglage. Ce signal de réglage a une valeur comprise dans un intervalle délimité par une valeur de tension haute par exemple 2,5 volts et une valeur de tension basse, par exemple 0,5 volts. Le circuit d'oscillation 1 comporte un dispositif de commande 5 dont une sortie est reliée à l'entrée 3 et a en charge de produire le signal de réglage. Ainsi, l'oscillateur 2 peut osciller à une fréquence dont une valeur est fonction d'une valeur de tension du signal de réglage en entrée 3. Dans la plupart des cas, on souhaite asservir la valeur de fréquence du signal en sortie 4 à une valeur de fréquence issue d'un oscillateur fixe 6 fournissant un signal à une fréquence donnée. Pour cela le dispositif de commande 5 comporte deux entrées 7 et 8. L'entrée 7 est reliée à une sortie de l'oscillateur fixe 6 et reçoit donc en entrée un signal de consigne dont une valeur de fréquence est fixe. L'entrée 8 est reliée, notamment par l'intermédiaire d'un circuit diviseur de fréquence 9 par N, à la sortie 4 de l'oscillateur 2. Ainsi, le dispositif de commande 5 fournit à l'entrée 3 un signal dont une valeur de potentiel est directement proportionnelle à une différence de phase et/ou de fréquence entre ces deux signaux. Lorsque les signaux présents sur les entrées 7 et 8 du dispositif de commande 5 sont en phase, la valeur de fréquence du signal en sortie 4 est égale à N fois la valeur de fréquence du signal de référence en entrée 7. Cependant lorsque les signaux présents sur les entrées 7 et 8 ne sont pas en phase le dispositif de commande 5 produit un signal en entrée 3 dont une valeur est croissante ou décroissante, de manière monotone, selon un signe de la comparaison entre les signaux présents sur les entrées 7 et 8. Pour ce faire, le dispositif de commande 5 comporte un comparateur de phase 10 et un filtre passe-bas 11. Ce comparateur de phase 10 comporte deux entrées dont une est reliée à l'entrée 7 et l'autre à l'entrée 8. Ce comparateur de phase 10 comporte en outre une sortie 12 est reliée à une entrée du filtre passe-bas 11 nommé filtre de boucle. Ce filtre de boucle 11 comporte une sortie reliée à l'entrée 3 de l'oscillateur 2 commandé par une tension.

L'oscillateur 2 commandé par une tension comporte une diode varicap 13 dont une anode est reliée à une masse du circuit. En outre, une cathode de cette diode 13 est reliée à l'entrée 3 par l'intermédiaire d'une résistance 14. A une valeur de potentiel, en entrée 3, correspond une valeur de capacité entre l'anode et la cathode de la diode varicap 13. L'oscillateur 2 commandé par une tension comporte un filtre résonant 15 avec une entrée 16 et une sortie 17 ainsi qu'un circuit actif 18. La cathode est reliée à l'entrée 16 du filtre résonant 15. Une valeur de fréquence de ce filtre résonant 15 dépend de la valeur de la capacité entre l'anode et la cathode de la diode varicap 13. Ainsi pour une nouvelle valeur de tension appliquée à l'entrée 3, la diode varicap 13 présente une nouvelle valeur de capacité entre son anode et sa cathode. Cette nouvelle valeur de capacité induit une nouvelle valeur de fréquence de résonance pour le filtre résonant 15. Une sortie 17 de ce filtre résonant 15 est reliée à une entrée du circuit actif 18 dont une sortie est reliée à la sortie 4 de l'oscillateur 2. Ce circuit actif 18 a en charge d'initier et d'entretenir une oscillation à la valeur de fréquence sélectionnée par le filtre résonant 15.

Dans l'état de la technique, pour augmenter une dynamique en sortie 4 de l'oscillateur 2 on augmente dans un premier temps l'intervalle dans lequel la tension de réglage peut varier. Pour cela on augmente la valeur de la tension électrique haute. Pour augmenter la valeur de la tension électrique haute en sortie du dispositif de commande 5, on relie une entrée 19 d'alimentation du dispositif de commande 5 à une sortie d'un dispositif de commutation d'alimentation 20. Ce dispositif de commutation d'alimentation 20 comporte deux entrées 21 et 22. L'entrée d'alimentation 21 est reliée à une première source de potentiel et la deuxième entrée 22 est reliée à une deuxième source de potentiel, plus élevée. Ainsi pour augmenter cette valeur de la tension électrique haute en entrée 3 de l'oscillateur 2 il suffit de sélectionner la deuxième entrée 22 du dispositif de commutation 20. Une commutation du dispositif de commutation 20 est obtenue, par exemple, par une commande par un microprocesseur (non représenté) d'un téléphone mobile.

La deuxième source de potentiel reliée à l'entrée 22 est produite en général à partir de la première source de potentiel et ce notamment grâce à un dispositif survolteur 23. Un tel dispositif survolteur 23 comporte généralement un hacheur. Il est commandé par un signal à une valeur de fréquence de l'ordre de 100 KHz. Ce dispositif survolteur 23 produit en sortie un potentiel continu dont une valeur est supérieure au potentiel de la première source de potentiel, et auquel se superpose un signal de bruit du hacheur. Cette superposition de signaux est appliquée en entrée du dispositif 19 de dispositif de commande 5 et est donc transmise à l'entrée 12 du filtre de boucle 11. Or, ce filtre 11 possède une bande passante de l'ordre de 200 KHz donc le bruit présent en entrée 11 de ce filtre n'est pas intégralement éliminé et se retrouve donc appliqué sur l'entrée 3 de l'oscillateur 2. De plus, la cathode de la diode varicap 13 est reliée, par l'intermédiaire de la résistance 14, à l'entrée 3. Ainsi le bruit présent sur l'entrée 3 se retrouve au moins en partie appliqué sur la cathode de la diode varicap 13.

Le bruit peut être défini comme étant un signal présentant des variations de potentiel rapides c'est-à-dire inférieures à une microseconde. A ces variations de potentiel sur la cathode de la diode varicap 13 on a des variations de capacité de la diode varicap 13. Ces variations de capacité produisent des variations de la valeur de la fréquence de résonance demandée ce qui a pour conséquence immédiate de dégrader une pureté spectrale du signal produit en sortie 4 de l'oscillateur 2.

Une première solution pour limiter l'effet du bruit issu du potentiel relié à l'entrée 22 consiste à augmenter une valeur du courant appliquée en entrée 19 du dispositif de commande 5. Ce faisant les sources de courant de la pompe à charge sont commandées par un courant plus fort, le bruit étant indépendant de l'intensité du courant, ses caractéristiques ne changent pas. On diminue ainsi un effet du bruit sur l'entrée 3. Il existe toujours un bruit sur cette entrée 3, mais il est plus faible. En contrepartie, une augmentation de la consommation du courant est nécessaire, ce qui diminue une autonomie d'un dispositif d'alimentation du téléphone mobile, notamment une batterie.

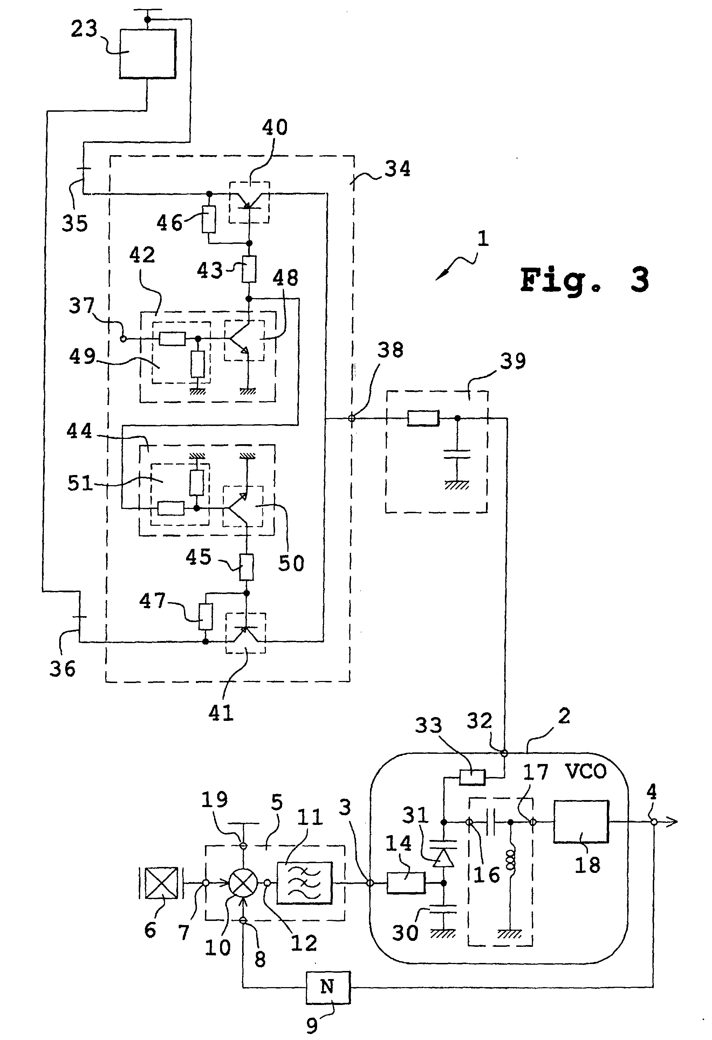

La figure 2 montre une amélioration, selon l'état de la technique, du circuit d'oscillation 1 afin de réduire encore une dégradation de la pureté spectrale du signal disponible en sortie 4 de l'oscillateur 2 Dans cette solution l'entrée 19 d'alimentation du dispositif de commande 5 est reliée à la première source de potentiel. Ainsi l'intervalle dans lequel le signal de réglage peut varier reste fixe et compris notamment entre 0,5 et 2,5 volts. Pour obtenir une augmentation de la dynamique en sortie 4 de l'oscillateur 2 on modifie quelque peu la structure de l'oscillateur 2. Plus précisément, on modifie la structure entre l'anode de la diode varicap 13 et la masse du circuit. C'est-à-dire qu'on relie entre l'anode de la diode varicap 13 et la masse une deuxième diode varicap 24 dont la cathode est reliée à l'anode de la diode varicap 13 et dont l'anode est reliée à la masse du circuit. On se retrouve ainsi avec deux diodes varicap en série. L'oscillateur 2 comporte en outre un autre dispositif de commande 25 dont une sortie 26 est reliée à la cathode de la diode 24.

Ce dispositif de commande 25 comporte deux entrées 27 et 28. L'entrée 27 est reliée à la première source de potentiel. L'entrée 28 reçoit un signal de commande issu notamment d'un microprocesseur (non représenté). Ce signal de commande comporte deux états. Un premier état correspond par exemple à un signal dont une valeur de potentiel est de l'ordre de zéro volt. A cette valeur de zéro volt présente sur l'entrée de commande 28 correspond une première valeur de potentiel produit en sortie 26 du dispositif 25. Un deuxième état correspond par exemple à un signal dont une valeur de potentiel est de l'ordre de trois volts. A cette valeur de trois volts présente sur l'entrée de commande 28 correspond une deuxième valeur de potentiel, produit en sortie 26.La deuxième valeur est plus faible que la première. Ces deux valeurs de potentiel peuvent être produites par exemple à partir d'un pont diviseur résistif dont une valeur d'une résistance dépend de la valeur présente sur l'entrée de commande 28. La diode varicap 24 reçoit selon le cas sur sa cathode une valeur de potentiel parmi deux valeurs différentes. Elle peut donc être réglée à deux valeurs de capacité différentes. La capacité associée à la deuxième valeur de potentiel est plus grande que la capacité associée à la première valeur de potentiel puisque la deuxième valeur de potentiel est plus faible. Ainsi, un condensateur équivalent aux bornes de la diode varicap 13 se retrouve en série avec un condensateur équivalent aux bornes de la diode varicap 24 pouvant avoir deux valeurs de capacité différentes. On obtient bien ainsi une augmentation de la dynamique en sortie 4 de l'oscillateur 2. En effet, lorsqu'on veut avoir une valeur de fréquence en sortie 4 supérieure à la valeur de fréquence haute, il suffit de faire passer la valeur de la commande à l'entrée 28 de l'état bas à l'état haut ou inversement.

Quand il est employé dans un téléphone mobile, le circuit 1 peut produire un signal à une fréquence de l'ordre de 1,4 GHz.

Il existe des applications où la diode varicap 24 est remplacée par une diode PIN. Cette diode PIN lorsqu'elle est polarisée en direct se comporte comme un court-circuit. Dans ce cas la sortie 26 du dispositif 25 se retrouve au même potentiel que la masse du circuit.

De préférence, on intercale entre la diode varicap 13 et la diode varicap 24 un condensateur 29 de capacité fixe. En effet, avec cette solution il n'y a qu'une source de potentiel, par exemple de 3 volts. Ainsi une différence de potentiel aux bornes de la diode varicap 13 est au plus de 3 volts. Or, du fait de la présence de la diode 24 une valeur de potentiel présente sur l'anode de la diode varicap 13 est positive et supérieure à zéro volt. En conséquence de quoi, les valeurs des capacités équivalentes des diodes sont grandes, ce qui donne une valeur basse à la fréquence de résonance. Avec le condensateur 29, on assure au circuit d'oscillation 1 une fréquence de résonance minimale, notamment proche d'une valeur de fréquence de fonctionnement de ce circuit d'oscillation par exemple 1,4 GHz.

Cette dernière solution présente encore des problèmes. En effet, on utilise deux diodes varicap pour réaliser un accord en fréquence. En pratique, un potentiel appliqué par la sortie 26 à la cathode de la diode varicap 24 est aussi appliqué à l'anode de la diode varicap 13. Donc en modifiant une valeur de capacité, on en modifie en fait deux. En outre, un courant consommé par le dispositif de commande 25 est encore assez élevé. De plus, il y a du bruit produit en sortie 26 car la résistance 14 laisse passer une fraction des signaux issus du filtre résonnant 15 qui peuvent donc se propager et générer du bruit à d'autres valeurs de fréquences notamment à cause de la présence de circuits non linéaires. En effet, la résistance 14 est une résistance de très forte valeur c'est-à-dire supérieures à 100 kilo-ohms. Aux très hautes fréquences, par exemple de l'ordre de 1,4 GHz, cette résistance 14 est censée se comporter comme une inductance. C'est-à-dire que des signaux à de telles fréquences ne peuvent la traverser car une inductance aux hautes fréquences agit comme un circuit ouvert quasi-parfait. La résistance 14 ne protège que le circuit 5. Un filtrage du signal sur la sortie 26 est délicat à mettre en oeuvre. En effet, si on modifie une valeur d'un composant alors toutes les autres valeurs doivent être réglées à nouveau. Ainsi, un problème est de pouvoir filtrer le signal produit par une source de potentiel indépendamment des dispositifs dans l'oscillateur 2 contrôlé par une tension.

La figure 3 montre le circuit d'oscillation 1 modifié selon l'invention. L'oscillateur 2 contrôlé par une tension comporte un condensateur 30 et une diode varicap 31 en série. Le condensateur 30 est relié par une électrode à la masse du circuit et par l'autre électrode à l'anode de la diode varicap 31. L'anode de la diode varicap 31 est en outre reliée à l'entrée 3 de commande de l'oscillateur 2 par l'intermédiaire de la résistance 14. La cathode de la diode varicap 31 est reliée à l'entrée 16 du filtre résonant 15. Dans l'invention, l'entrée 3 de l'oscillateur 2 est reliée à l'anode de la diode varicap 31 et non plus à la cathode comme dans les solutions de l'état de la technique.

Si on considère un potentiel fixe sur la cathode de la diode varicap 31 une différence de potentiel appliquée à la diode varicap 31 est égale à la valeur de ce potentiel fixe moins la valeur du potentiel appliquée sur l'anode. Or l'anode est reliée à l'entrée 3 de l'oscillateur 2 et subit donc les variations de la tension de réglage. Or, la tension de réglage en entrée 3 varie entre 0,5 volt et 2,5 volts. Donc si par exemple une valeur du potentiel fixe sur la cathode de la varicap 31 est égale à 3 volts alors la différence de potentiel aux bornes de la diode varicap varie entre 3 - 0,5 = 2,5 volts et entre 3 - 2,5 = 0,5 volt. Ceci détermine une première plage de variation de la valeur de la capacité. Si maintenant le potentiel fixe est porté à une valeur de 4,5 volts alors la différence de potentiel aux bornes de la diode varicap 31 varie entre 4,5 - 0,5 = 4 et entre 4,5 - 2,5 = 2 volts. Ainsi la différence de potentiel aux bornes de la diode varicap 31 peut varier de 0,5 volt à 4 volts si le potentiel fixe appliqué sur la cathode de la diode varicap 31 peut commuter entre 3 volts et 4,5 volts.

L'invention propose un tel dispositif. Pour cela l'oscillateur 2 comporte une entrée 32 d'alimentation. Cette entrée 32 est reliée à la cathode de la diode varicap 31 par l'intermédiaire d'une résistance 33. Cette résistance 33 joue le même rôle que la résistance 14 précédente. Le circuit d'oscillation 1 comporte un dispositif de commutation 34 d'alimentation. Ce dispositif de commutation 34 d'alimentation comporte une entrée 35 reliée à une première source de potentiel et une entrée 36 reliée à une deuxième source de potentiel. Il comporte en outre une sortie 38 reliée à l'entrée 32 de l'oscillateur 2 contrôlé par une tension. La deuxième source de potentiel est de valeur supérieure à la première source de potentiel. Le dispositif de commutation 34 comporte en outre une entrée de commande 37. Cette entrée de commande 37 permet de sélectionner une source de potentiel parmi les deux reliées aux entrées 35 et 36. Ainsi on peut obtenir sur la cathode de la diode varicap 31 deux potentiels fixes comme indiqué ci-dessus. Par ailleurs, la deuxième source de potentiel reliée à l'entrée 36 est obtenue à partir de la première source de potentiel reliée à l'entrée 35 comme précédemment avec le dispositif survolteur 23. Donc la source de potentiel reliée à l'entrée 36 est porteuse de bruit et se retrouve donc en sortie 38. Pour cette raison on insère entre la sortie 38 et l'entrée 32 de l'oscillateur 2 un filtre passe-bas 39. De préférence la fréquence de coupure du filtre 39 est très basse, bien inférieure à la bande passante du filtre 11.

Dans un exemple préféré, le dispositif de commutation 34 comporte un premier et un deuxième transistor bipolaire 40 et 41 respectivement dont des émetteurs sont reliés aux entrées 35 et 36 respectivement et des collecteurs à la sortie 38. Le dispositif de commutation 34 comporte en outre un premier circuit de commande 42. Ce circuit de commande 42 comporte une entrée reliée à l'entrée de commande 37 et une sortie du circuit de commande 42 est reliée d'une part à une base du transistor 40 par l'intermédiaire d'une résistance 43 et d'autre part à une entrée d'un deuxième circuit de commande 44 identique au circuit de commande 42. Une sortie du circuit de commande 44 est reliée à une base du transistor 41 par l'intermédiaire d'une résistance 45. De plus, une résistance 46 de polarisation est reliée entre la base du transistor 40 et son émetteur. On a de même une résistance 47 de polarisation entre la base du transistor 41 et son émetteur. Le circuit de commande 42 comporte un transistor 48 dont un collecteur est relié à la sortie du circuit de commande 42 et donc aussi à la résistance 43. L'émetteur est quant à lui relié à la masse du circuit. Le circuit de commande 42 comporte en outre un pont diviseur de tension résistif 49 dont une entrée est reliée à l'entrée 37 et une sortie est reliée à la base du transistor 48. Le circuit de commande 44 est réalisé de la même manière que le circuit de commande 42 à partir d'un transistor 50 et d'un pont diviseur de tension résistif 51. On obtient ainsi une commande complémentaire des transistors 40 et 41.

En effet, en appliquant sur l'entrée de commande 37 une valeur de potentiel suffisante pour rendre le transistor 48 saturé alors le transistor 40 se retrouve passant, l'entrée du circuit de commande 44 se retrouve à un potentiel proche d'un potentiel de la masse. Le transistor 50 est donc dans un état bloqué ce qui a pour effet de garder le transistor 41 dans un état bloqué. Ainsi, la sortie 38 est reliée à la première source de potentiel. A l'inverse, en bloquant le transistor 48, le transistor 50 est passant car l'entrée du circuit de commande 44 est reliée par l'intermédiaire des résistances 43 et 46 à la source de potentiel 35. Dans ce cas la sortie 38 est reliée à la deuxième source de potentiel.

Dans une variante on remplace les transistors 40, 41, 48 et 50 par des transistors à effet de champ, dans ce cas dans la description précédente les émetteurs deviennent des sources, les collecteurs des drains, et les bases des grilles. Les ponts diviseurs de tension résistifs 49, 51 deviennent inutiles. En effet les transistors à effet de champ peuvent être commandés par des potentiels dont une valeur est supérieure à 0,7 volt.

De plus, l'entrée 32 étant reliée, à l'intérieur de l'oscillateur 2, à la cathode de la diode varicap 31 et à l'entrée 16 du filtre résonant 15, l'entrée étant capacitive, un courant circulant par cette entrée est très faible de l'ordre d'une centaine de microampères. Dans l'invention le dispositif de commutation est indépendant de l'oscillateur 2. C'est à dire que des éléments du dispositif de commutation 34 sont indépendants de l'oscillateur 2 commandé par une tension. En conséquence un filtrage réalisé par le filtre 39 peut être très important, par exemple de l'ordre de la dizaine de hertz voir moins. Ce qui est nettement suffisant pour éliminer la majeure partie du bruit qui est appliqué sur la diode varicap 31. On améliore donc la pureté spectrale du signal disponible en sortie 4 de l'oscillateur 2 tout en augmentant la dynamique.

Dans un exemple préféré la première source de potentiel est de 3 volts et la deuxième source de potentiel est de 4,5 volts et est produite à partir de la première source de potentiel par le dispositif survolteur 23. On pourrait très bien envisager d'autres valeurs pour l'une et ou l'autre des sources de potentiel.

Dans la description on a considéré une application de l'oscillateur 2 dans une boucle à verrouillage de phase. Cependant, l'oscillateur 2 de l'invention peut très bien être utilisé tel quel dans un dispositif dans lequel il n'y a pas de contraintes particulières relative à la stabilité du signal en sortie 4 de l'oscillateur 2 par rapport au signal de référence. La boucle à verrouillage de phase n'est qu'un dispositif d'asservissement assurant à un signal une valeur de fréquence stable dans le temps.

## Revendications

1. Circuit d'oscillation (1) comportant un oscillateur (2) commandé par une tension électrique sur une première entrée (3), et un dispositif de commande (5) relié à cette entrée, le dispositif de commande (5) étant alimenté par une première source de potentiel et produisant un signal de réglage, **caractérisé en ce que** cet oscillateur (2) comporte une deuxième entrée (32) reliée à un dispositif de commutation d'alimentation (34) entre cette première source de potentiel et une deuxième source de potentiel.

2. Circuit d'oscillation selon la revendication 1 **caractérisé en ce qu'**une sortie (38) du dispositif de commutation (34) est reliée à une entrée d'un filtre passe-bas (39) dont une sortie est reliée à la deuxième entrée (32) de l'oscillateur (2).

3. Circuit d'oscillation selon l'une des revendications 1 à 2, **caractérisé en ce qu'**il comporte une diode varicap (31) à capacité variable dont une cathode est reliée à la deuxième entrée (32) par l'intermédiaire d'une résistance (33) et dont une anode est reliée à la première entrée par l'intermédiaire d'une résistance (14), et **en ce qu'**il comporte en outre un circuit résonant (15), la cathode étant par ailleurs reliée à une entrée de ce circuit résonant (15) et permettant de sélectionner une valeur de fréquence pour une oscillation et l'anode étant par ailleurs reliée à un potentiel de masse du circuit par l'intermédiaire d'un condensateur (30).

4. Circuit d'oscillation selon l'une des revendications 1 à 3, **caractérisé en ce que** le dispositif de commutation (34) comporte un premier et un deuxième transistor (40, 41) dont des émetteurs sont reliés à la première source et à la deuxième source de potentiel respectivement et dont des collecteurs sont reliés à l'entrée (38) du dispositif de commutation (34).

5. Circuit d'oscillation selon la revendication 4, **caractérisé en ce que** les deux transistors (40, 41) sont commandés de façon complémentaire par un signal de commande appliqué à une base d'un transistor.

6. Circuit d'oscillation selon l'une des revendications 1 à 5, **caractérisé en ce que** la deuxième source de potentiel a une valeur de potentiel supérieure à la première source de potentiel et que cette deuxième source de potentiel est produite à partir de la première source de potentiel par un dispositif survolteur (23).

7. Circuit d'oscillation selon l'une des revendications 1 à 6, **caractérisé en ce qu'**une valeur de potentiel de la première source de potentiel est de 3 volts, et **en ce qu'**une valeur de potentiel de la deuxième source de potentiel est de 4,5 volts.

## Patentansprüche

1. Schwingungskreis (1), umfassend einen Oszillator (2), der durch eine elektrische Spannung an einem ersten Eingang (3) gesteuert wird, und eine Steuervorrichtung (5), die mit diesem Eingang verbunden ist, wobei die Steuervorrichtung (5) von einer ersten Potentialquelle angespeist wird und ein Regelsignal erzeugt, **dadurch gekennzeichnet, daß** dieser Oszillator (2) einen zweiten Eingang (32) umfasst, der mit einer Umschaltvorrichtung (34) für die Anspeisung zwischen dieser ersten Potentialquelle und einer zweiten Potentialquelle verbunden ist.

2. Schwingungskreis nach Anspruch 1, **dadurch gekennzeichnet, daß** ein Ausgang (38) der Umschaltvorrichtung (34) mit einem Tiefpassfiltereingang (39) verbunden ist, von dem ein Ausgang mit dem zweiten Eingang (32) des Oszillators (2) verbunden ist.

3. Schwingungskreis nach einem der Ansprüche 1 bis 2, **dadurch gekennzeichnet, daß** er eine Varicap-Diode (31) mit variabler Kapazität umfasst, von der eine Kathode an den zweiten Eingang (32) mit Hilfe eines Widerstandes (33) angeschlossen ist, und von der eine Anode an den ersten Eingang mit Hilfe eines Widerstandes (14) angeschlossen ist, und daß er ferner einen Resonanzkreis (15) umfasst, wobei die Kathode überdies mit einem Eingang dieses Resonanzkreises (15) verbunden ist und es ermöglicht, einen Frequenzwert für eine Schwingung auszuwählen, und wobei die Anode überdies mit einem Massepotential des Kreises mit Hilfe eines Kondensators (30) verbunden ist.

4. Schwingungskreis nach einem der Ansprüche 1 bis 3, **dadurch gekennzeichnet, daß** die Umschaltvorrichtung (34) einen ersten und einen zweiten Transistor (40, 41) umfasst, deren Sender an die erste Quelle bzw. an die zweite Potentialquelle angeschlossen sind und deren Kollektoren an den Eingang (38) der Umschaltvorrichtung (34) angeschlossen sind.

5. Schwingungskreis nach Anspruch 4, **dadurch gekennzeichnet, daß** die beiden Transistoren (40, 41) auf komplementäre Weise durch ein Steuersignal gesteuert werden, das an eine Basis eines Transistors angelegt wird.

6. Schwingungskreis nach einem der Ansprüche 1 bis 5, **dadurch gekennzeichnet, daß** die zweite Potentialquelle einen größeren Potentialwert als die erste Potentialquelle hat, und daß diese zweite Potentialquelle aus der ersten Potentialquelle durch einen Spannungserhöher (23) erzeugt wird.

7. Schwingungskreis nach einem der Ansprüche 1 bis 6, **dadurch gekennzeichnet, daß** ein Potentialwert der ersten Potentialquelle 3 Volt beträgt und daß ein Potentialwert der zweiten Potentialquelle 4,5 Volt beträgt.

## Claims

1. An oscillation circuit (1) comprising an oscillator (2) controlled by an electrical voltage on a first input (3), and a control unit (5) connected to this input, the control unit (5) being supplied by a first source of potential and producing a control signal, **characterised in that** this oscillator (2) includes a second input (32) connected to a supply switching device (34) between this first source of potential and a second source of potential.

2. The oscillation circuit according to claim 1, **characterised in that** an output (38) of the switching device (34) is connected to an input of a low-pass filter (39), an output of which is connected to the second input (32) of the oscillator (2).

3. The oscillation circuit according to any one of claims 1 to 2, **characterised in that** it includes a variable-capacity varicap diode (31), a cathode of which is connected to the second input (32) via a resistor (33) and an anode of which is connected to the first input via a resistor (14), and **in that** it further includes a resonance circuit (15), the cathode being connected moreover to an input of this resonance circuit (15) and permitting a frequency value to be selected for an oscillation and the anode being connected moreover to an earth potential of the circuit via a capacitor (30) .

4. The oscillation circuit according to any one of claims 1 to 3, **characterised in that** the switching device (34) includes a first and a second transistor (40, 41), the emitters of which are connected to the first source and to the second source of potential respectively and the collectors of which are connected to the input (38) of the switching device (34).

5. The oscillation circuit according to claim 4, **characterised in that** the two transistors (40, 41) are controlled in a complementary manner by a control signal applied at a base of a transistor.

6. The oscillation circuit according to any one of claims 1 to 5, **characterised in that** the second source of potential has a potential value higher than the first source of potential and that this second source of potential is produced from the first source of potential by a booster device (23).

7. The oscillation circuit according to any one of claims 1 to 6, **characterised in that** the potential value of the first source of potential is 3 volts, and **in that** a potential value of the second source of potential is 4.5 volts.
